# EUROPÄISCHE PATENTSCHRIFT

(11) **EP 0 886 992 B1**
(45) Veröffentlichungstag und Bekanntmachung des Hinweises auf die Patenterteilung: **11.08.1999**
(21) Anmeldenummer: 97915326.9
(22) Anmeldetag: 03.03.1997
(51) Int. Cl.: H05K 7/14, G06F 1/18

(54) **GERÄTECHASSIS FÜR ELEKTRONISCHE GERÄTE**
EQUIPMENT CHASSIS FOR ELECTRONIC EQUIPMENT
CHASSIS POUR APPAREILS ELECTRONIQUES

(30) Priorität: 13.03.1996 DE 19609887; 13.03.1996 DE 19609891
(43) Veröffentlichungstag der Anmeldung: 30.12.1998
(73) Patentinhaber: Siemens Nixdorf Informationssysteme AG, 33106 Paderborn (DE)
(72) Erfinder: KNOOP, Franz-Josef, D-33142 Büren (DE); BLUME, Johannes, D-37688 Beverungen (DE); ELLEBRECHT, Friedhelm, D-33034 Brakel (DE); FAHLE, Paul, D-59602 Rüthen (DE); FLOTHO, Helmut, D-33181 Fürstenberg (DE); HESSE, Ronny, D-33189 Schlangen (DE); SCHARNETZKE, Rainer, D-33175 Bad Lippspringe (DE); SCHMIDT, Heinrich, D-33129 Delbrück (DE)
(74) Vertreter: Epping, Wilhelm, Dr.-Ing.
(86) Internationale Anmeldenummer: DE9700386
(87) Internationale Veröffentlichungsnummer: WO9734452

(56) Entgegenhaltungen:
- DE-A- 2 652 933
- DE-A- 4 104 984
- GB-A- 1 089 888
- US-A- 3 733 523
- US-A- 4 862 326
- US-A- 4 867 696
- US-A- 5 023 754

## Beschreibung

Die Erfindung betrifft ein Gerätechassis für elektronische Geräte, insbesondere Datenverarbeitungsgeräte gemäß dem Oberbegriff des Anspruchs 1.

Es sind Gerätechassis bekannt, bei denen üblicherweise an dem Rahmen Führungsschienen befestigt sind, in welche die Einschübe eingeschoben werden können. Die Einschübe haben Blenden, die dann wiederum am Rahmen mit Schrauben oder Schnellverschlüssen befestigt werden, um beispielsweise die Vorderfront des Gerätes zu verschließen und eine elektromagnetische Abschirmung zu gewährleisten. Die Einschübe sind an ihrer Rückseite mit Steckern versehen, die in entsprechende Gegenstecker an einer sogenannten Geräterückwand in Eingriff treten, die mit dem Rahmen verbunden ist. Die Einschübe bestehen üblicherweise aus mit elektronischen Bauteilen bestückten Schaltungsplatinen, die ein normiertes Maß haben. Inzwischen gibt es eine Reihe von unterschiedlichen Normgrößen für derartige Schaltungsplatinen und für bestimmte elektronische Einheiten.

Ein Chassis der eingangs genannten Art ist beispielsweise aus der US 37 33 523 bekannt. Dabei sind in die aus Aluminiumdruckguß bestehenden Führungsplatten die Führungsschienen zur Aufnahme der Einschübe eingeformt. Zwischen den Schienen befinden sich Lüftungsschlitze durch die Kühlluft zum Kühlen der auf den Einschüben befindlichen Bauelemente hindurchtreten kann.

Will ein Hersteller mit Chassis der vorstehend genannten Art eine Gerätefamilie herstellen, deren einzelne Geräte je nach Kundenwunsch unterschiedliche Ausstattungen haben, d.h. auch unterschiedliche Einschübe enthalten, so entsteht das Problem, daß hierfür unterschiedlich bemessene Gerätechassis und Führungsplatten verwendet werden müssen. Dies erhöht die Produktionskosten aufgrund einer größeren Anzahl von Teilen und einer komplizierteren Montage. Dabei ist zu berücksichtigen, daß bei jedem dieser Geräte eine einwandfreie elektromagnetische Abschirmung der elektronischen Komponenten gewährleistet sein muß, so daß das fertige Gerät eine zumindest für bestimmte elektromagnetische Wellen undurchdringliche geschlossene metallische äußere Abschirmung haben muß, wobei zum Teil auch bestimmte Einheiten innerhalb des Gerätes gegeneinander abschirmbar sein sollen. Schließlich soll das Gerät wartungsfreundlich sein, d.h. die einzelnen Einheiten innerhalb des Gerätes sollen ohne größeren Montageaufwand zugänglich und gegebenenfalls auswechselbar sein.

Aus der GB 10 89 888 ist bereits ein Chassis mit gitterförmigen Montageplatten bekannt, die jeweils ein Lochmuster mit kreisförmigen Gitteröffnungen haben, die in einem bestimmten Rastermaß über die Fläche der Montageplatten verteilt sind. An den Montageplatten können Führungsschienen für die Einschübe an praktisch beliebigen Stellen und beliebiger Orientierung befestigt werden, indem zapfenförmige Fortsätze an der Unterseite der Führungsschienen in die Löcher des Lochmusters eingeklipst werden. Dabei ist je zwei Führungsschienen, in welche ein Geräteeinschub einschiebbar ist, auch eine Halteschiene für einen Stecker zugeordnet, in den ein mit dem Geräteeinschub verbundener Randstecker eingesteckt werden kann. Abgesehen davon, daß die dargestellte wahlweise Anordnung der Führungsschienen parallel zu bestimmten Lochreihen oder diagonal zu den Lochreihen aus geometrischen Gründen bei dem angegebenen Lochmuster nur im Ausnahmefall möglich sein dürfte, ist eine seitliche Verschiebung der Steckerhalter bei der aus der GB 10 89 888 bekannten Lösung nicht möglich, da diese mit den Zapfen genau in die jeweiligen Löcher gesetzt werden. Für einzelne Stecker mag das in Ordnung sein. Für Rückwände mit mehreren Befestigungslöchern, deren gegenseitiger Abstand toleranzbehaftet ist, ist die aus der GB 10 89 888 bekannte Lösung aber ungeeignet.

Der Erfindung liegt die Aufgabe zugrunde, ein Gerätechassis der eingangs genannten Art anzugeben, das mit einer begrenzten Anzahl einheitlicher Bauteile den Aufbau einer Vielfalt von unterschiedlichen Geräten sowie eine einfache Montage und Demontage derselben erlaubt und eine zuverlässige Abschirmung der fertigen Geräte gewährleistet.

Diese Aufgabe wird durch die im kennzeichnenden Teil des Anspruchs 1 angegebenen Merkmale gelöst.

Die erfindungsgemäß ausgebildeten Führungsplatten ermöglichen es aufgrund der Form und Anordnung der Gitteröffnungen mit geeigneten in die Gitteröffnungen eingreifenden Befestigungselementen eine oder mehrere Geräterückwände und Einschübe an den Führungsplatten zu befestigen, wobei der Raum innerhalb des Gerätechassis entsprechend der gewünschten Geräteausstattung relativ frei eingeteilt werden kann. Gleichzeitig sorgen die Führungsplatten für eine elektromagnetische Abschirmung an zumindest zwei Flächen des Gerätes. Durch die quadratische Form der Rasteröffnungen und durch das Netz von senkrecht zueinander gerichteten Stegen können die Führungsschienen und die Befestigungsschienen für eine Geräterückwand einerseits exakt ausgerichtet werden andererseits aber etwas relativ zueinander verschoben werden, wenn dies aufgrund von innerhalb eines Toleranzbereiches liegenden Maßabweichungen notwendig sein sollte.

Bei einer ersten Ausführungsform der Führungsschiene ist der Isolierkörper im Querschnitt U-förmig mit einem über die gesamte Länge der Führungsschiene durchgehenden Quersteg ausgebildet, so daß die eingeschobene Platine mit ihrem Rand auf dem Quersteg des Isolierkörpers gleiten kann. Bei dieser Lösung mindert die Dicke des Quersteges das zwischen den Führungsplatten bestehende Maß für die Einschübe. Wird für die Einschübe der vollständige Abstand zwischen den Führungsplatten benötigt, so kann man Führungsschienen verwenden, bei denen die Leisten des Isolierkörpers durch mehrere Querstege verbunden sind, deren Länge und gegenseitiger Abstand so gewählt sind, daß sie gleichzeitig in die Gitteröffnungen der Führungsplatte eingreifen können. Damit stehen die eingeschobenen Platinen mit ihren Rändern direkt auf den Führungsplatten auf. Im übrigen können jedoch die Führungsschienen genauso wie im ersten Fall an beliebigen Stellen der Führungsplatte montiert werden.

Vorzugsweise sind die Eingriffselemente an dem Isolierkörper hakenförmig zum Hintergreifen eines Gittersteges ausgebildet, so daß die Führungsschienen an dem Gitter zuverlässig festgelegt werden können.

Um eine elektrische Verbindung der Einschübe mit den Führungsplatten sicherzustellen und damit eine elektromagnetische Abschirmung der einzelnen Einschübe zu gewährleisten, ist vorzugsweise in dem Isolierkörper ein metallischer Kontaktstreifen derart angeordnet, daß er sowohl mit einer in die Führungschiene eingeschobenen Platine oder Karte als auch mit der Führungsplatte in leitender Verbindung steht.

Zum leichteren Einschieben der Platinen in die Führungsschienen ist es zweckmäßig, wenn an mindestens einem Längsende des Isolierkörpers Einweisungsschrägen für das Einführen des jweiligen Einschubes oder der jeweiligen Platine ausgebildet sind.

Eingangs wurde bereits darauf hingewiesen, daß es genormte Platinen unterschiedlicher Größe gibt. Bestimmte elektronische Einheiten und Module werden auf Platinen bestimmter Größe aufgebaut. Um den modulartigen Aufbau der Geräte mit dem erfindungsgemäßen Chassis zu erleichtern, ist für dieses erfindungsgemäß ein quaderförmiger Käfig vorgesehen, der mit einer Quaderseite an einer an die Geräterückwand steckbaren, in das Gerätechassis einschiebbaren Geräteplatine befestigt ist und parallel zur Geräeteplatine gerichtete Führungen zum Einführen von Käfigeinschüben hat und in dem eine mit der Geräteplatine elektrisch verbundene Käfigrückwand angeordnet ist, die senkrecht zu der mit dem Käfig verbundenen Geräteplatine gerichtet ist und Stecker zur Verbindung mit den Käfigeinschüben hat. Die Geräteplatine entspricht in ihren Abmessungen den anderen zwischen die Führungsplatten einschiebaren Einschüben. Innerhalb des Käfigs jedoch können Einschübe mit völlig anderen Abmessungen eingesetzt werden, wobei der Käfig insgesamt eine in sich abgeschirmte abgeschlossene Einheit bilden kann. Das Chassis braucht in keiner Weise verändert zu werden.

Zum Schließen der Abschirmung an der Vorderseite der Gerätechassis haben die Geräteplatinen in an sich bekannter Weise an ihrem der Geräterückwand entgegengesetzten Rand jeweils eine Metallblende, die an ihren Längsenden mechanisch und elektrisch leitend mit dem Gerätechassis verbindbar ist. Erfindungsgemäß sind die Abmessungen des Käfigs und der Abstand der Käfigrückwand von der Blende der mit dem Käfig verbundenen Geräteplatine in Anpassung an die Abmessungen der Käfigplatinen so gewählt, daß mit den Käfigeinschüben verbundene Blenden nach dem Einschieben der Käfigeinschübe in derselben Ebene wie die Blenden der Geräteplatinen liegen und an mindestens einem ihrer Enden mechanisch und elektrisch leitend mit dem Gerätechassis verbindbar sind. D.h. trotz der sonst anderen Abmessungen können die Blenden der Käfigeinschübe zusammen mit den Blenden der Geräteeinschübe eine gemeinsame Front bilden und auch ebenso wie die Geräteplatinen aus dem Gerät einzeln herausgezogen werden.

Da jedoch das seitliche Rastermaß der Käfigeinschübe verschieden von dem seitlichen Rastermaß der Geräteeinschübe sein kann, wird erfindungsgemäß vorgeschlagen, daß zur Verbindung der Platinenblenden mit dem Rahmen des Gerätechassis an diesem Anschraubleisten befestigt sind, in denen Gewindebohrungen zum Anschrauben der Platinenblenden ausgebildet sind, wobei die gegenseitigen Abstände der Gewindebohrungen einem oder mehreren Rastermaßen für die nebeneinander anzuordnenden Geräte- und Käfigplatinen entsprechen und wobei an jeder Anschraubleiste in gleichförmigen mittleren Abständen voneinander Schraubenmuttern derart schwimmend angeordnet sind, daß sie um eine vorgegebene Strecke in Längsrichtung der Anschraubleiste beweglich sind. Damit können eventuelle Unterschiede im Rastermaß zwischen den Käfigeinschüben und den Geräteeinschüben ausgeglichen werden.

Das erfindungsgemäße Chassis ermöglicht mit denselben leicht zu montierenden Grundelementen den Aufbau elektronischer Geräte mit unterschiedlicher Ausstattung, insbesondere Einschüben unterschiedlicher Größe und Anordnung. Dadurch lassen sich die Materialkosten für das Chassis und die Montagekosten für die Geräte erheblich senken. Die einzelnen Baugruppen sind leichter zugänglich und die Wartungsfreundlichkeit der Geräte wird erhöht.

Weitere Merkmale und Vorteile der Erfindung ergeben sich aus der folgenden Beschreibung, welche in Verbindung mit den beigefügten Zeichnungen die Erfindung anhand von Ausführungsbeispielen erläutert. Es zeigen:
- Figur 1: eine teilweise schematische perspektivische Frontansicht eines unter Verwendung des erfindungsgemäßen Chassis aufgebauten Geräteschrankes mit einem Käfigeinschub,
- Figur 2: eine perspektivische Draufsicht auf eine Führungsplatte mit einer daran befestigten Geräterückwand,
- Figur 3: eine Draufsicht auf einen Schenkel eines Befestigungswinkels zur Befestigung einer Geräterückwand an einer Führungsplatte,
- Figur 4: eine Draufsicht auf den anderen Schenkel des Befestigungswinkels,
- Figur 5: eine perspektivische Ansicht einer ersten Ausführungsform einer Führungsleiste,
- Figur 6: einen vergrößerten Querschnitt durch den Isolierkörper der Führungsleiste entlang Linie VI-VI in Figur 5,
- Figur 7: eine perspektivische Darstellung eines in den Isolierkörper der Führungsschiene gemäß Figur 5 eingesetzten Kontaktstreifens,
- Figur 8: eine Unteransicht einer zweiten Ausführungsform einer Führungsschiene,
- Figur 9: eine Seitenansicht der in Figur 8 dargestellten Führungsschiene,
- Figur 10: eine Draufsicht auf die in Figur 8 dargestellte Führungsschiene,
- Figur 11: eine erste Ausführungsform eines hakenförmigen Elementes an den in den Figur 5 bis 10 dargestellten Führungsschienen,
- Figur 12: eine zweite Form eines hakenförmigen Elementes an den in den Figur 5 bis 10 dargestellten Führungsschienen,
- Figur 13: eine vergrößerte Darstellung eines in das Gerätechassis einschiebbaren Käfigs zur Aufnahme von Einschüben,
- Figur 14: eine schematische Darstellung der Verbindung einer Käfigrückwand mit einer Geräteplatine und mit Käfigeinschüben,
- Figur 15: eine perspektivische Darstellung einer Anschraubleiste für Einschubblenden,
- Figur 16: einen Schnitt durch die Anschraubleiste entlang Linie XVI-XVI in Figur 15.

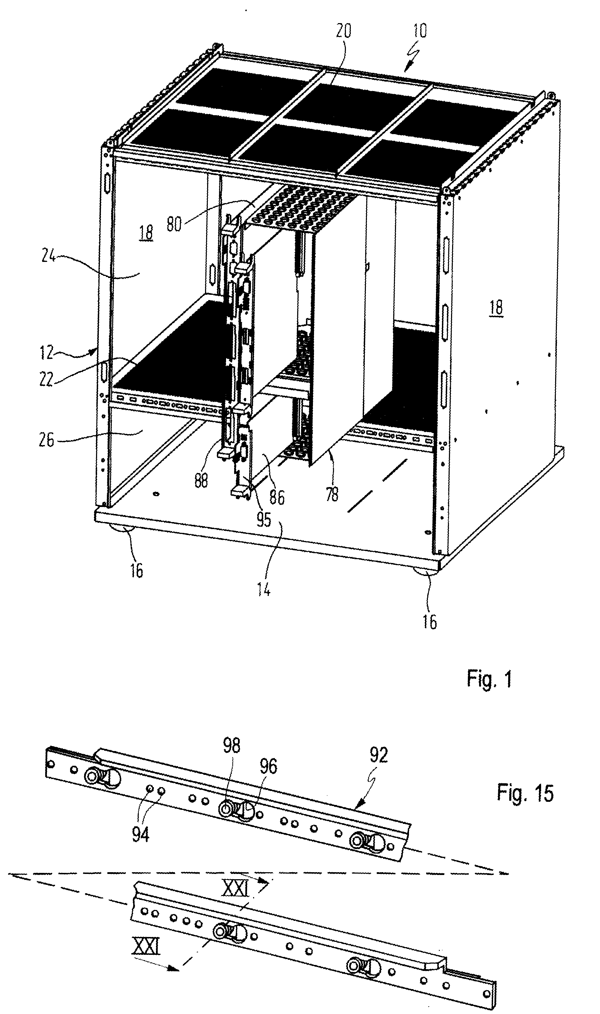

Das in Figur 1 allgemein mit 10 bezeichnete Gerätechassis umfaßt einen quaderförmigen offenen Rahmen 12, der aus miteinander verschraubten oder verschweißten Metallprofilen besteht. Der Rahmen 12 ist auf einer Bodenplatte 14 befestigt, die ihrerseits auf Füßen oder Rollen 16 aufliegt. Die Seitenflächen des Rahmens 12 sind durch Wände 18 geschlossen. Die Oberseite des Rahmens wird von einer ersten Führungsplatte 20 gebildet. Der von dem Rahmen 12 umschlossene Innenraum wird durch eine zu der oberen Führungsplatte 20 parallele untere Führungsplatte 22 in einen zur Aufnahme von Einschüben bestimmten oberen Raum 24 und einen unteren Raum 26 unterteilt, der zur Aufnahme mindestens eines Netzteiles oder anderer Versorgungseinheiten bestimmt ist.

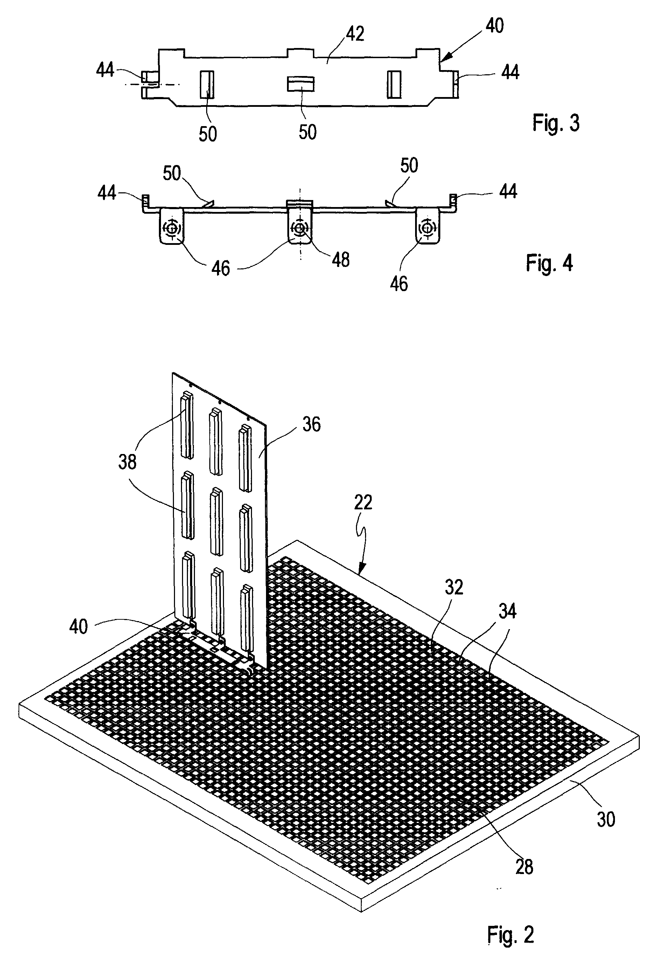

Wie Figur 2 zeigt, sind die Führungsplatten 20 und 22 im wesentlichen von einem Gitter 28 gebildet, das von einem geschlossenen Rahmen 30 umgeben ist. Die Gitteröffnungen 32 sind quadratisch und durch zueinander senkrechte Stege 34 voneinander getrennt. Der Rasterabstand zwischen den Stegen ist vorzugsweise entsprechend einem üblichen Rastermaß gewählt und beträgt beispielsweise 12,5 mm in X- und Y-Richtung. Gleichzeitig muß die Abschirmwirkung der Führungsplatten 20 und 22 beachtet werden. Die Größe der Öffnungen 32 muß also an die Frequenz der zu erwartenden elektromagnetischen Strahlung angepaßt sein, um eine Abschirmung zu gewährleisten.

Figur 2 zeigt die Befestigung einer Geräterückwand 36 an der Führungsplatte 22. Als Geräterückwand wird in der vorliegenden Beschreibung eine Schaltungsplatine bezeichnet, die Stekker 38 zum Anschluß von Einschüben trägt und die Einschübe untereinander sowie mit den Versorgungseinheiten verbindet.

Zur Befestigung der Geräterückwand 36 mit den Führungsplatten 20, 22 dient ein Befestigungswinkel oder eine Befestigungsschiene 40. Diese umfaßt einen in Figur 3 sichtbaren ersten Schenkel 42 in Form eines Metallstreifens, der an seinen freien Enden rechtwinklig umgebogene Klauen 44 (Figur 4) hat. Der zweite Schenkel des Befestigungswinkels 40 wird von senkrecht zum ersten Schenkel 42 gerichteten Laschen 46 gebildet, die Gewindebohrungen 48 zum Anschrauben der Geräterückwand 36 haben, wie dies in Figur 2 dargestellt ist. In dem Schenkel 42 sind ferner Laschen 50 ausgestanzt und schräg aus der Ebene des Schenkels 42 herausgedrückt, wie dies Figur 4 zeigt.

Der Abstand der Klauen 44 voneinander ist so bemessen, daß die Klauen 44 beim Auflegen des Schenkels 42 auf die Gitterfläche 28 der oberen oder unteren Führungsplatte 22 straff über zwei Stege 34 greifen, so daß der Befestigungswinkel 40 unter leichter Auslenkung der Klauen 44 auf der Gitterfläche 28 festgeklemmt wird. Dabei greifen die ausgestanzten Laschen 50 in zwischen den Klauen 44 liegende Öffnungen 32 und kommen mit ihren freien Kanten zur Anlage an den die Öffnungen begrenzenden Stegen 34. Dadurch wird der Befestigungswinkel 40 innerhalb des Rastermaßes exakt auf der jeweiligen Führungsplatte 20, 22 fixiert. Wie man aus Figur 2 erkennt, kann die Führungsplatte 36 mit Hilfe dieses Befestigungswinkels auf einfachste Weise an einer beliebigen Stelle innerhalb des Rastermaßes in X- und Y-Richtung positioniert werden.

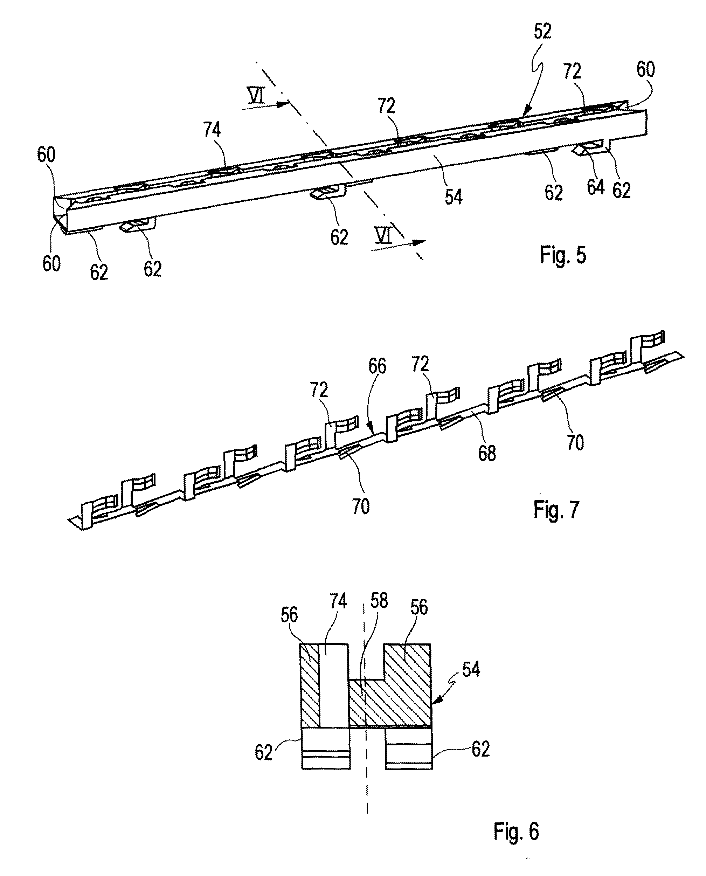

Die in das Gerät einzuschiebenden Einschübe oder Schaltungsplatinen werden senkrecht zur Geräterückwand 36 eingeschoben. Zur Halterung und Führung der Einschübe an den Führungsplatten 20, 22 dienen Führungsleisten, die anhand der Figur 5 bis 12 erläutert werden sollen. Die in Figur 5 dargestellte Führungsleiste 52 umfaßt einen im Querschnitt U-förmigen Isolierkörper 54 (Figur 6) mit zwei zueinander parallelen Leisten 56, die durch eine sich über die gesamte Länge erstrekkenden U-Quersteg 58 miteinander verbunden sind. An den Längsenden der Führungsschiene 52 sind Einweisungsschrägen 60 ausgebildet, um das Einführen von Einschüben in die Führungsschiene 52 zu erleichtern.

Nahe den Längsenden und in einem mittleren Bereich der Führungsschiene 52 hat diese an ihrer Unterseite jeweils ein Paar von hakenförmigen Eingriffselementen 62. Die Haken jedes Paares sind um ein Rastermaß in Längsrichtung gegeneinander versetzt und haben in Querrichtung einen Abstand voneinander. Die nahe dem in Figur 5 rechten Ende der Führungsschiene 52 vorgesehene Haken 62 haben an ihrer Innenseite eine kleine Rastnase 64. Die Führungsschiene 52 wird mit den Haken 62 in Öffnungen 32 der Führungsplatte 20 oder 22 eingesetzt und dann in Längsrichtung verschoben, so daß die Haken 62 unter Stege 34 greifen und die Führungsschiene 52 dadurch an der Führungsplatte 20, 22 festlegen. Dabei rasten die Nasen 64 hinter dem betreffenden Steg 34 ein und verhindern somit ein unbeabsichtigtes Verschieben der Führungsschiene 52.

Um einen elektrischen Kontakt zwischen einer in eine Führungsschiene 52 eingeschobenen Platine und der jeweiligen Führungsplatte 20, 22 zu gewährleisten, ist in die Führungsschiene 52 ein in Figur 7 abgebildeter metallischer Kontaktstreifen 66 eingelegt. Dieser umfaßt einen durchgehenden Mittelstreifen 68, aus dem im Rastermaß Zungen 70 nach unten herausgebogen sind und von dem nach oben Kontaktfahnen 72 rechtwinklig abstehen. Der Mittelstreifen 68 liegt an der Unterseite des Isolierkörpers 54 an und erstreckt sich zwischen den Haken 62. Zur Aufnahme der Kontaktfahnen 72 sind an den aneinander zugekehrten Innenseiten der Leisten 56 jeweils Aussparungen 74 vorgesehen, die zur Unterseite des Isolierkörpers 54 hin offen sind (Figur 6), so daß die Kontaktfahnen 72 von unten her in die Aussparungen 74 eingeschoben werden können. Beim Aufschieben der Führungsschiene 52 auf die Gitterstege 34 der jeweiligen Führungsplatte 20, 22 wird der Mittelstreifen 68 des Kontaktstreifens 66 fest gegen das metallische Gitter gedrückt. Die Zungen 70 greifen unter die Stege 34. Der Kontakt zur eingeschobenen Platine wird über die in den Einschubspalt hinein gewölbten Kontaktfahnen 72 hergestellt.

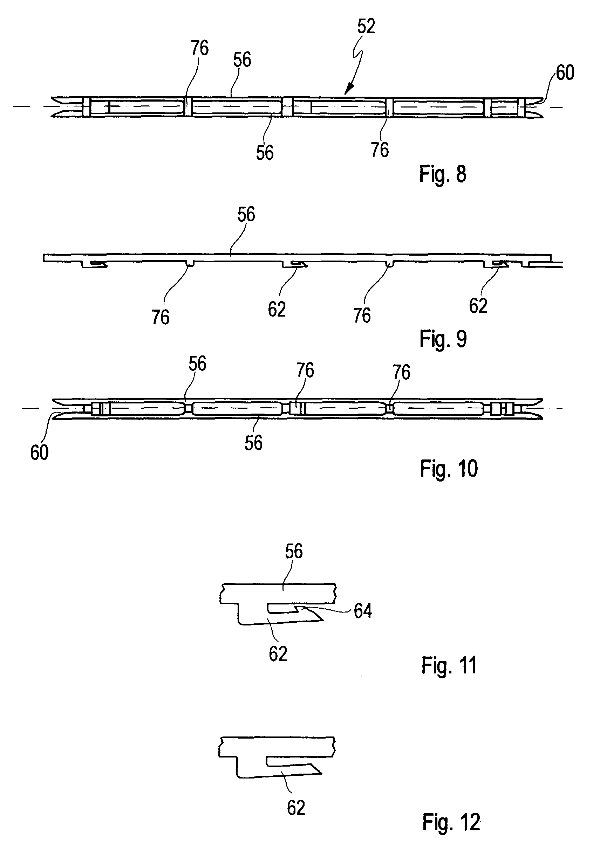

Die Figur 8 bis 10 zeigen eine weitere Ausführungsform der Führungsschiene. Bei diesem Ausführungsbeispiel besteht die Führungsschiene nur aus dem Isolierkörper 54. Die beiden Längsleisten 56 des Isolierkörpers sind dabei über schmale Querstege 76 miteinander verbunden, an denen auch die Haken 62 ausgebildet sind. Der Abstand zwischen zwei Querstegen 76 entspricht einem ganzzahligen Vielfachen des Rastermaßes der Öffnungen 32 in den Führungsplatten 20, 22. Daher greifen beim Aufsetzen der Führungsschienen 54 die Querstege 76 in Öffnungen 32, so daß die Längsleisten 56 unmittelbar auf den Führungsplatten 20, 22 aufliegen. Daher gleiten auch die in den Führungsschienen eingeschobenen Platinen unmittelbar auf den Führungsplatten 20, 22, so daß eine Kontaktierung der Platinen über Kontaktleisten 66 wie bei der Ausführungsform gemäß den Figur 5 bis 7 nicht erforderlich ist. Man gewinnt auf diese Weise die der Dicke der Querstege 58 bei der Ausführungsform gemäß den Figur 5 bis 7 entsprechende Höhe.

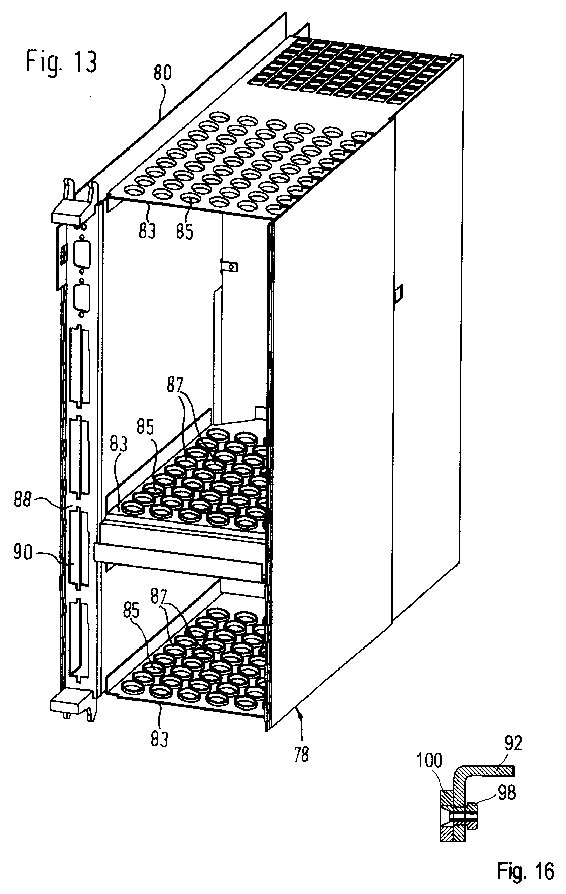

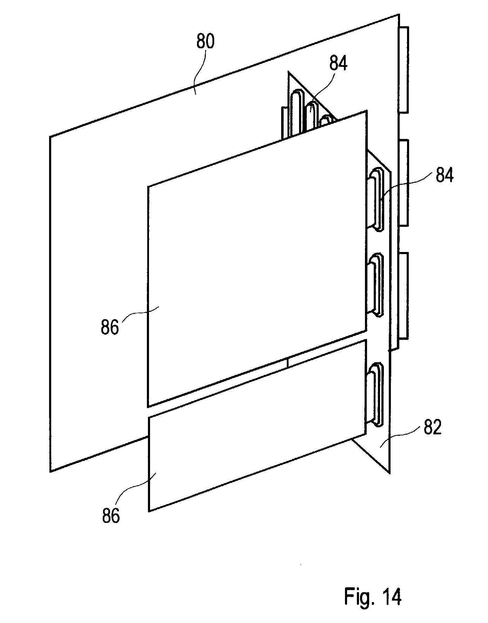

In der Figur 13 ist eine spezielle Art von Einschub für das in Figur 1 dargestellte Chassis in vergrößerter Darstellung abgebildet. Der dort dargestellte Einschub umfaßt einen quaderförmigen Käfig 78, der an einer Platine 80 befestigt ist, die ihrerseits für einen Einschub in das Gerätechassis und eine Verbindung mit der Geräterückwand 36 ausgebildet ist. Innerhalb des Einschubkäfigs 78 befindet sich eine Käfigrückwand 82, die über nicht dargestellte Stecker mit der Geräteplatine 80 verbunden ist und ihrerseits Stecker 84 trägt, an welche wiederum in den Einschubkäfig 78 eingeschobene Karten oder Platinen 86 ansteckbar sind, wie dies die Figur 14 schematisch zeigt. Auf diese Weise können in demselben Chassis ohne Veränderung des Aufbaues desselben Karten mit unterschiedlichen Maßen eingesetzt werden. Der Einschubkäfig 78 seinerseits kann wiederum bis auf die Front eine vollständige metallische Abschirmung für die in ihm enthaltenen Einschübe 86 bilden.

Der in Figur 13 dargestellte Käfig 78 hat Böden 83 mit jeweils mehreren Reihen kreisrunder Öffnungen 85. Die diese Öffnungen 85 umgebenden Stege 87 bilden zusammen Führungen für einzuschiebende Karten oder Platinen. Alternativ hierzu können auch Böden mit dem Gitterraster der Führungsplatten 20, 22 in Verbindung mit Führungsschienen 52 verwendet werden.

Um die einzelnen Platinen oder Einschübe in das Chassis einschieben, an dem Chassis befestigen und aus dem Chassis herausziehen zu können, tragen die Platinen wie beispielsweise die in Figur 13 dargestellte Platine 80 eine Frontblende 88. Die aus Metall gefertigte Blende dient ferner dazu, die Vorderfront des Chassis 10 hinsichtlich elektromagnetischer Störstrahlung abzuschirmen und enthält Steckeröffnungen 90 für die Aufnahme von Steckern für das Anschließen von Peripheriegeräten. Diese Blenden werden an ihrem oberen und ihrem unteren Ende an einer in Figur 15 dargestellten Anschraubleiste 92 befestigt, die am Chassis 10 entlang der jeweiligen Führungsplatte 20, 22 angeordnet ist. Die Anschraubleiste 92 hat eine Reihe von Gewindebohrungen 94, deren Abstände so gewählt sind, daß Blenden unterschiedlicher, aber genormter Breite an derselben Leiste angeschraubt werden können. Damit nun auch die Blenden 95 der in den Käfig 78 eingeschobenen Karten oder Platinen 86 mit in die Vorderfront des Chassis 10 integriert werden können, wobei die Breite der Blenden dieser Einschübe von der vorher genannten Normbreite abweichen kann, sind in schlüssellochförmigen Aussparungen 96 in der Anschraubleiste 92 Schraubenmuttern 98 mit Hilfe eines Gleitsteines 100 (Figur 16) in Längsrichtung der Anschraubleiste 92 verschiebbar gelagert. Damit kann die von der Norm abweichende Lage von Schraubenlöchern in den Platinenblenden ausgeglichen werden und man kann unterschiedlich breite Blenden an den Geräteplatinen und den Käfigplatinen in einer gemeinsamen geschlossenen Front an dem Gerätechassis festschrauben.

Die vorstehende Beschreibung zeigt, daß das erfindungsgemäße Chassis mit denselben Grundelementen einen flexiblen Aufbau elektronischer Geräte ermöglicht, wobei die Montage des Chassis und der Einbau der Einheiten in das Chassis außerordentlich einfach ist. Die eingebauten Einheiten sind leicht zugänglich. Es besteht auch die Möglichkeit, Geräte nachzurüsten, solange noch Platz innerhalb des Chassis vorhanden ist.

## Patentansprüche

1. Gerätechassis für elektronische Geräte, insbesondere Datenverarbeitungsgeräte, mit einem quaderförmigen metallischen Rahmen (12) zur Aufnahme von Geräteeinschüben (80) und mindestens zwei rechteckigen, gitterförmigen Führungsplatten (20, 22) aus Metall, deren Gitteröffnungen (32) in einem vorgegebenen Rastermaß über die Fläche der jeweiligen Führungsplatte (20, 22) verteilt und durch senkrecht zueinander gerichtete Stege (34) voneinander getrennt sind, und die parallel zu einer Rahmenseite in einem der Höhe der vorgegebenen Geräteeinschübe (80) entsprechenden Abstand an dem Rahmen (12) befestigt sind, **dadurch gekennzeichnet**, daß die Gitteröffnungen (32) quadratisch geformt sind, daß mindestens eine Befestigungsschiene (40) zur Halterung einer Stecker (38) für den Anschluß der Geräteeinschübe (80) tragenden Geräterückwand (36) an den Führungsplatten (20, 22) vorgesehen ist und zum Einstecken in die Gitteröffnungen (32) bestimmte Fortsätze (44) hat, deren Abstand voneinander ein Vielfaches des Rastermaßes ist, und daß an der Führungsplatte (20, 22) festlegbare Führungsschienen (52) zum Einschieben mindestens eines karten- oder platinenförmigen Geräteeinschubes (80) vorgesehen sind, umfassend jeweils einen Isolierkörper (54), der aus zwei zueinander parallelen, einen Aufnahmespalt für den Geräteeinschub (80) begrenzenden Leisten (56) besteht, die durch mindestens einen Quersteg (58; 76) miteinander verbunden sind, und der an der Außenseite des mindestens einen Quersteges (58; 76) mindestens zwei Eingriffselemente (62) hat, die in Längsrichtung der Führungsschiene (52) einen einem ganzzahligen Vielfachen des Rastermaßes entsprechenden Abstand voneinander haben und zum Eingriff in Gitteröffnungen (32) der Führungsplatte (20, 22) bestimmt sind.

2. Gerätechassis nach Anspruch 1, **dadurch gekennzeichnet**, daß die Fortsätze (44) der metallischen Befestigungsschiene (40) von geringfügig elastisch auslenkbaren Klauen gebildet sind.

3. Gerätechassis nach Anspruch 1 oder 2, **dadurch gekennzeichnet**, daß die Befestigungsschiene (40) in Form eines Winkels ausgebildet ist, dessen einer Schenkel (42) die Klauen (44) trägt und zur Anlage an der jeweiligen Führungsplatte (20, 22) bestimmt ist und dessen anderer Schenkel mindestens eine Befestigungslasche (46) zur Verbindung mit der Geräterückwand (36) umfaßt.

4. Gerätechassis nach Anspruch 3, **dadurch gekennzeichnet**, daß an dem zur Anlage an der Führungsplatte (20, 22) bestimmten Schenkel (42) im Rastermaß mindestens zwei Vorsprünge (50) ausgebildet sind, die beim Einstecken der Fortsätze (44) in Gitteröffnungen (32) der Führungsplatte (20, 22) an zwei zueinander senkrechten Stegen (34) zur Anlage kommen.

5. Gerätechassis nach einem der Ansprüche 1 bis 4, **dadurch gekennzeichnet**, daß der Isolierkörper (54) im Querschnitt U-förmig mit einem über die gesamte Länge der Führungsschiene durchgehenden Quersteg (58) ausgebildet ist.

6. Gerätechassis nach einem der Ansprüche 1 bis 4, **dadurch gekennzeichnet**, daß die Leisten (56) des Isolierkörpers (54) durch mehrere Querstege (76) verbunden sind, deren Länge und gegenseitiger Abstand so gewählt sind, daß sie gleichzeitig in die Gitteröffnungen (32) der Führungsplatte (20, 22) eingreifen können.

7. Gerätechassis nach einem der Ansprüche 1 bis 6, **dadurch gekennzeichnet**, daß die Eingriffselemente (62) hakenförmig zum Hintergreifen eines Gittersteges (34) ausgebildet sind.

8. Gerätechassis nach einem der Ansprüche 1, 5 und 7, **dadurch gekennzeichnet**, daß in dem Isolierkörper (54) ein metallischer Kontaktstreifen (66) derart angeordnet ist, daß er sowohl mit einer in die Führungsschiene (52) eingeschobenen Platine oder Karte (80) als auch mit der Führungsplatte (20, 22) in leitender Verbindung steht.

9. Gerätechassis nach einem der Ansprüche 1 bis 8, **dadurch gekennzeichnet**, daß an mindestens einem Längsende des Isolierkörpers (54) Einweisungsschrägen (60) für das Einführen eines Einschubes (80) ausgebildet sind.

10. Gerätechassis nach einem der Ansprüche 1 bis 9 **gekennzeichnet durch** einen quaderförmigen Käfig (78), der mit einer Quaderseite an einer an die Geräterückwand (36) steckbaren, in das Gerätechassis (10) einschiebbaren Geräteplatine (80) befestigt ist und parallel zur Geräteplatine (80) gerichtete Führungen zum Einführen von Käfigeinschüben (86) hat und in dem eine mit der Geräteplatine (80) elektrisch verbundene Käfigrückwand (82) angeordnet ist, die senkrecht zu der mit dem Käfig verbundenen Geräteplatine (80) gerichtet ist und Stecker (84) zur Verbindung mit den Käfigeinschüben (86) hat.

11. Gerätechassis nach Anspruch 10, **dadurch gekennzeichnet**, daß die Geräteplatinen (80) an ihrem jeweiligen der Geräterückwand (36) abgewandten Rand eine Metallblende (88) tragen, die an ihren Längsenden mechanisch und elektrisch leitend mit dem Gerätechassis (10) verbindbar ist und daß die Abmessungen des Käfigs (78) und der Abstand der Käfigrückwand (82) von der Blende (88) der mit dem Käfig (78) verbundenen Geräteplatine (80) in Anpassung an die Abmessungen der Käfigplatinen (86) so gewählt sind, daß mit den Käfigeinschüben (86) verbundene Blenden (95) nach dem Einschub der Käfigeinschübe (86) in derselben Ebene wie die Blenden (88) der Geräteplatinen (80) liegen und an mindestens einem ihrer Enden mechanisch und elektrisch mit dem Gerätechassis (10) verbindbar sind.

12. Gerätechassis nach Anspruch 11, **dadurch gekennzeichnet**, daß zur Verbindung der Platinenblenden (88) mit dem Rahmen (12) des Gerätechassis an diesem Anschraubleisten (92) befestigt sind, in denen Gewindebohrungen (94) zum Anschrauben der Platinenblenden (88) ausgebildet sind, wobei die gegenseitigen Abstände der Gewindebohrungen (94) einem oder mehren Rastermaßen für die nebeneinander anzuordnenden Geräte- und Käfigplatinen (80; 86) entsprechen und daß an jeder Anschraubleiste (92) in gleichförmigen mittleren Abständen voneinander Schraubenmuttern (98) derart schwimmend angeordnet sind, daß sie um eine vorgegebenen Strecke in Längsrichtung der Anschraubleiste (92) beweglich sind.

13. Gerätechassis nach einem der Ansprüche 1 bis 12, **gekennzeichnet durch** eine nahe der Chassisaußenseite angeordnete Anschlußeinheit (130) mit mindestens einer Anschlußklemme und eine Leiteranordnung mit mindestens einem metallischen stabförmigen biegesteifen Leiter (134), der an seinen Längsenden jeweils eine Kontaktlasche (136) hat und zwischen den Kontaktlaschen (136) von einem Isoliermantel (138) umgeben ist, wobei an dem Gerätechassis zwischen der Anschlußeinheit (130) und einer Anschlußstelle (148) an der Geräterückwand (122) eine Schiene (142) mindestens einem hakenförmigen Element (144) befestigt ist, in das der Leiter (134) einlegbar ist.

## Claims

1. Equipment chassis for electronic equipment, in particular data processing equipment, having a cube-shaped metallic frame (12) to accommodate withdrawable units (80) and at least two rectangular, grid-like metal guide panels (20, 22), the grid openings (32) of which are distributed at a predefined grid spacing over the area of the respective guide panel (20, 22) and are separated from one another by webs (34) that are oriented at right angles to one another, and which are fastened to the frame (12), parallel to one side of the frame, at a spacing corresponding to the height of the predefined withdrawable units (80), characterized in that the grid openings (32) are of square shape, in that at least one fastening rail (40) is provided to hold a connector (38) for connecting the equipment backplane (36), which carries withdrawable units (80), to the guide panels (20, 22), and has extensions (44) which are intended to be plugged into the grid openings (32) and whose spacing from one another is a multiple of the grid spacing, and in that guide rails (52), which can be fixed to the guide panel (20, 22), are provided for the insertion of at least one card-shaped or circuit-board-shaped withdrawable unit (80), each comprising an insulating body (54), which comprises two strips (56) which are parallel to each other and bound a receiving gap for the withdrawable unit (80) and are connected to each other by at least one transverse web (58; 76), and which insulating body (54) has, on the outside of the at least one transverse web (58; 76), at least two engaging elements (62) which, in the longitudinal direction of the guide rail (52), have a spacing from one another which corresponds to an integer multiple of the grid spacing and are intended to engage in grid openings (32) in the guide panel (20, 22).

2. Equipment chassis according to Claim 1, characterized in that the extensions (44) of the metallic fastening rail (40) are formed by slightly resiliently deflectable claws.

3. Equipment chassis according to Claim 1 or 2, characterized in that the fastening rail (40) is constructed in the form of an angle, whose one limb (42) carries the claws (44) and is intended to rest on the respective guide panel (20, 22), and whose other limb includes at least one fastening lug (46) to be connected to the equipment backplane (36).

4. Equipment chassis according to Claim 3, characterized in that at least two projections (50) are constructed at the grid spacing on the limb (42) that is intended to rest on the guide panel (20, 22) and, when the extensions (44) are inserted into grid openings (32) in the guide panel (20, 22), the projections (50) come to rest on two mutually perpendicular webs (34).

5. Equipment chassis according to one of Claims 1 to 4, characterized in that the insulating body (54) is constructed with a U-shaped cross-section having a transverse web (58) that is continuous over the entire length of the guide rail.

6. Equipment chassis according to one of Claims 1 to 4, characterized in that the strips (56) of the insulating body (54) are connected by a plurality of transverse webs (76) whose length and mutual spacing are selected such that they can engage simultaneously in the grid openings (32) in the guide panel (20, 22).

7. Equipment chassis according to one of Claims 1 to 6, characterized in that the engaging elements (62) are of hook-like construction in order to engage behind a grid web (34).

8. Equipment chassis according to one of Claims 1, 5 and 7, characterized in that a metallic contact strip (66) is arranged in the insulating body (54) in such a way that it is conductively connected both to a circuit board or card (80) inserted into the guide rail (52) and to the guide panel (20, 22).

9. Equipment chassis according to one of Claims 1 to 8, characterized in that insertion guide bevels (60) for the insertion of a withdrawable unit (80) are constructed at at least one longitudinal end of the insulating body (54).

10. Equipment chassis according to one of Claims 1 to 9, characterized by a cube-shaped cage (78), which is fastened by way of one cube side to an equipment circuit board (80) which can be plugged onto the equipment backplane (36) and can be inserted into the equipment chassis (10), and has guides which are oriented parallel to the equipment circuit board (80) and are intended for the insertion of cage withdrawable units (86), and in which there is arranged a cage backplane (82) which is electrically connected to the equipment circuit board (80), is oriented at right angles to the equipment circuit board (80) connected to the cage and has connectors (84) for connecting it to the cage withdrawable units (86).

11. Equipment chassis according to Claim 10, characterized in that, on their respective edge facing away from the equipment backplane (36), the equipment circuit boards (80) carry a metal bezel (88) which, at its longitudinal ends, can be connected mechanically and electrically conductively to the equipment chassis (10), and in that the dimensions of the cage (78) and the spacing of the cage backplane (82) from the bezel (88) of the equipment circuit board (80) connected to the cage (78) are selected to match the dimensions of the cage circuit boards (86) such that, after the cage withdrawable units (86) have been inserted, bezels (95) connected to the cage withdrawable units (86) lie in the same plane as the bezels (88) of the equipment circuit boards (80) and, at at least one of their ends, can be connected mechanically and electrically to the equipment chassis (10).

12. Equipment chassis according to Claim 11, characterized in that, in order to connect the circuit board bezels (88) to the frame (12) of the equipment chassis, screw-on strips (92) are fastened to the latter and have threaded holes (94) made in them for screwing on the circuit board bezels (88), the mutual spacings of the threaded holes (94) corresponding to one or more grid spacings for the equipment and cage circuit boards (80; 86) to be arranged beside one another, and in that nuts (98) are arranged in a floating manner on each screw-on strip (92), at uniform average spacings from one another, in such a way that they can be moved over a predefined travel in the longitudinal direction of the screw-on strip (92).

13. Equipment chassis according to one of Claims 1 to 12, characterized by a connection unit (130) which is arranged close to the chassis outer side and has at least one connecting terminal and a conductor arrangement with at least one metallic, rod-like, flexurally rigid conductor (134) which has a contact tab (136) at each of its longitudinal ends and, between the contact tabs (136), is surrounded by an insulating sheath (138), there being fastened to the equipment chassis, between the connection unit (130) and a connection point (148) on the equipment backplane (122), a rail (142) having at least one hook-like element (144), into which the conductor (134) can be inserted.

## Revendications

1. Châssis pour appareils électroniques, en particulier pour appareils de traitement de données, comportant un cadre (12) métallique parallélépipédique pour recevoir des racks (80) d'appareil, et comportant au moins deux plaques (20, 22) de guidage rectangulaires en grille métallique, plaques dont les ouvertures (32) de grille sont réparties sur la surface de la plaque (20, 22) respective de guidage suivant une dimension prescrite de quadrillage et sont séparées les unes des autres par des entretoises (34) mutuellement perpendiculaires, et plaques qui sont fixées sur le cadre (12) parallèlement à un côté du cadre, à une distance correspondant à la hauteur des racks (80) prédéfinis d'appareil, **caractérisé** en ce que les ouvertures (32) de grille sont carrées, en ce qu'au moins un profilé (40) de fixation pour maintenir une paroi (36) arrière d'appareil portant des connecteurs (38) pour le raccordement des racks (80) d'appareil est prévu sur les plaques (20, 22) de guidage et possède des prolongements (44), destinés à s'emboîter dans les ouvertures (32) de grille et dont la distance mutuelle est un multiple de la dimension de quadrillage, et en ce que des profilés (52) de guidage, pouvant être immobilisés sur la plaque (20, 22) de guidage, sont prévus pour l'insertion d'au moins un rack (80) d'appareil en forme de carte ou de plaquette, profilés qui comprennent respectivement un corps (54) isolant, qui est constitué de deux barrettes (56) parallèles, délimitant une fente réceptrice pour le rack (80) d'appareil et mutuellement reliées par au moins une branche (58; 76) transversale, et qui possède sur le côté extérieur de la ou les branches (58 ; 76) transversales au moins deux éléments (62) d'engagement, dont la distance mutuelle dans la direction longitudinale du profilé (52) de guidage correspond à un multiple entier de la dimension de quadrillage et qui sont destinés à s'engager dans des ouvertures (32) de grille de la plaque (20, 22) de guidage.

2. Châssis d'appareil suivant la revendication 1, **caractérisé** en ce que les prolongements (44) du profilé (40) métallique de fixation sont formés par des griffes à légère déflexion élastique.

3. Châssis d'appareil suivant la revendication 1 ou 2, **caractérisé** en ce que le profilé (40) de fixation est réalisé sous la forme d'une cornière, dont une branche (52) porte les griffes (44) et est destinée à s'appliquer contre la plaque (20, 22) respective de guidage, et dont l'autre branche comporte au moins une patte de fixation (46) pour l'assemblage avec la paroi (36) arrière d'appareil.

4. Châssis d'appareil suivant la revendication 3, **caractérisé** en ce qu'au moins deux saillies (50) sont formées suivant la dimension de quadrillage sur la branche (42) destinée à s'appliquer contre la plaque (20, 22) de guidage, saillies qui, lors de l'emboîtement des prolongements (44) dans des ouvertures (32) de grille de la plaque (20, 22) de guidage, viennent s'appliquer contre deux entretoises (34) mutuellement perpendiculaires.

5. Châssis d'appareil suivant l'une des revendications 1 à 4, **caractérisé** en ce que le corps (54) isolant est réalisé avec une section en forme de U, dont le dos (58) du U s'étend continûment sur toute la longueur du profilé de guidage.

6. Châssis d'appareil suivant l'une des revendications 1 à 4, **caractérisé** en ce que les barrettes (56) du corps (54) isolant sont reliées par plusieurs branches (76) transversales, dont la longueur et la distance mutuelle sont choisies de telle sorte qu'elles peuvent s'engager simultanément dans les ouvertures (32) de grille de la plaque (20, 22) de guidage.

7. Châssis d'appareil suivant l'une des revendications 1 à 6, **caractérisé** en ce que les éléments (62) d'engagement sont réalisés en forme de crochets destinés à s'engager derrière une entretoise (34) de la grille.

8. Châssis d'appareil suivant l'une des revendications 1, 5 et 7, **caractérisé** en ce qu'une bande (66) métallique de contact est disposée dans le corps (54) isolant de telle sorte qu'elle se trouve en liaison conductrice à la fois avec la plaque (20, 22) de guidage et avec une plaquette ou carte (80) insérée dans le profilé (52) de guidage.

9. Châssis d'appareil suivant l'une des revendications 1 à 8, **caractérisé** en ce que des biais (60) de guidage pour l'introduction d'un rack (80) sont formés à au moins une extrémité longitudinale du corps (54) isolant.

10. Châssis d'appareil suivant l'une des revendications 1 à 9, **caractérisé** par une cage (78) parallélépipédique, qui est fixée par un côté du parallélépipède contre une plaquette (80) d'appareil pouvant être enfichée sur la paroi (36) arrière d'appareil et insérée dans le châssis (10) d'appareil, et qui possède des guides dirigés parallèlement à la plaquette (80) d'appareil pour l'introduction de racks (86) de cage, et dans laquelle est disposée une paroi (82) arrière de cage reliée électriquement à la plaquette (80) d'appareil, paroi qui est orientée perpendiculairement à la plaquette (80) d'appareil assemblée à la cage et qui possède des connecteurs (84) pour l'assemblage avec les racks (86) de cage.

11. Châssis d'appareil suivant la revendication 10, **caractérisé** en ce que les plaquettes (80) d'appareil portent, sur leur bord respectif opposé à la paroi (36) arrière d'appareil, un cache (88) métallique qui, à ses extrémités longitudinales, peut être assemblé mécaniquement et en conduction électrique au châssis (10) d'appareil, et en ce que les dimensions de la cage (78) et la distance entre la paroi (82) arrière de cage et le cache (88) de la plaquette (80) d'appareil assemblée à la cage (78) sont choisies, en adaptation aux dimensions des plaquettes (86) de cage, de telle sorte que des caches (95) assemblés aux racks (86) de cage se trouvent, à la suite de l'insertion des racks (86) de cage, dans le même plan que les caches (88) des plaquettes (80) d'appareil et peuvent être, à au moins une de leurs extrémités, assemblés mécaniquement et électriquement au châssis (10) d'appareil.

12. Châssis d'appareil suivant la revendication 11, **caractérisé** en ce que, pour l'assemblage des caches (88) de plaquette au cadre (12) du châssis d'appareil, des barrettes (92) de vissage sont fixées sur ce dernier, dans lesquelles sont ménagés des taraudages (94) pour visser les caches (88) de plaquette, les distances entre taraudages (94) correspondant à une ou plusieurs dimensions modulaires pour les plaquettes (80 ; 86) d'appareil et de cage à disposer en juxtaposition, et en ce que, sur chaque barrette (92) de vissage, des écrous (98) sont disposés, à des distances uniformes de centre à centre, en montage flottant de telle sorte qu'ils peuvent être déplacés d'une distance prescrite dans la direction longitudinale de la barrette (92) de vissage.

13. Châssis d'appareil suivant l'une des revendications 1 à 12, **caractérisé** par une unité (130) de raccordement, disposée à proximité du côté extérieur du châssis et pourvue d'au moins une borne de raccordement et d'un agencement de conducteurs comprenant au moins un conducteur (134) métallique en forme de barreau, rigide en flexion, qui possède à ses extrémités longitudinales une patte (136) de contact respective et qui est entouré, entre les pattes (136) de contact, par une gaine (138) isolante, un profilé (142) étant fixé sur le châssis d'appareil entre l'unité de raccordement (130) et un point (148) de raccordement sur la paroi (122) arrière d'appareil, profilé qui est pourvu d'au moins un élément (144) en forme de crochet, dans lequel le conducteur (134) peut être inséré.
